# EUROPEAN PATENT APPLICATION

(11) **EP 0 615 292 A1**
(43) Date of publication of application: **14.09.1994**
(21) Application number: 94103116.3
(22) Date of filing: 02.03.1994
(51) Int. Cl.: H01L 29/72, H01L 29/10

(54) **Insulated gate bipolar transistor**

(30) Priority: 10.03.1993 JP 48957/93
(71) Applicant: HITACHI, LTD., Chiyoda-ku, Tokyo 101 (JP)
(72) Inventor: Takahashi, Makoto, Hitachi Daiyon Kyoshinryo B311, Kokubunji-shi (JP); Toyabe, Toru, Kokubunji-shi (JP); Kamohara, Shiroo, Hitachi Daiyon Kyoshinryo B309, Kokubunji-shi (JP); Matsuo, Hitoshi, Kokubunji-shi (JP); Ohkura, Yasuyuki, Hachioji-shi (JP); Itoh, Satoshi, 502, Onumacho-2-chome, Kodaira-shi (JP); Tanaka, Junko, Kawaguchi-shi (JP); Maruyama, Kishiko, Hitachi Ozaki Haitsu 305, Kokubunji-shi (JP)
(74) Representative: Strehl Schübel-Hopf Groening & Partner

(57) **Abstract**

In an insulated gate bipolar transistor, a majority carrier, such as holes, in a collector layer (10) can be prevented from being injected into a region ranging from a region of an under layer of a gate electrode (16) of the base layer (11) adjacent to the collector layer (10) to a region except an under layer of an emitter electrode (15) by forming a potential barrier (110a) for the majority carrier in the collector layer (10) into the base layer (11) adjacent to the collector layer (10). The potential barrier (110a) can be an insulator, a highly doped region (n⁺ if the majority carriers are holes), or a heterojunction constructed by using a material different than that of the substrate. Also, the majority carrier in the collector layer (10) can be prevented from flowing into the emitter (13) from the region of the under layer of the gate electrode (16) of the base layer adjacent to the collector layer (14) or the region except the under layer of the emitter electrode (15) through the base layer (12) adjacent to the emitter layer (13). Thereby latch-up of the parasitic thyristor can be prevented and the turn-off time can be reduced, while the other characteristics remain unchanged.

## Description

### BACKGROUND OF THE INVENTION

The present invention relates to semiconductor devices and, more particularly, is directed to an insulated gate type bipolar transistor.

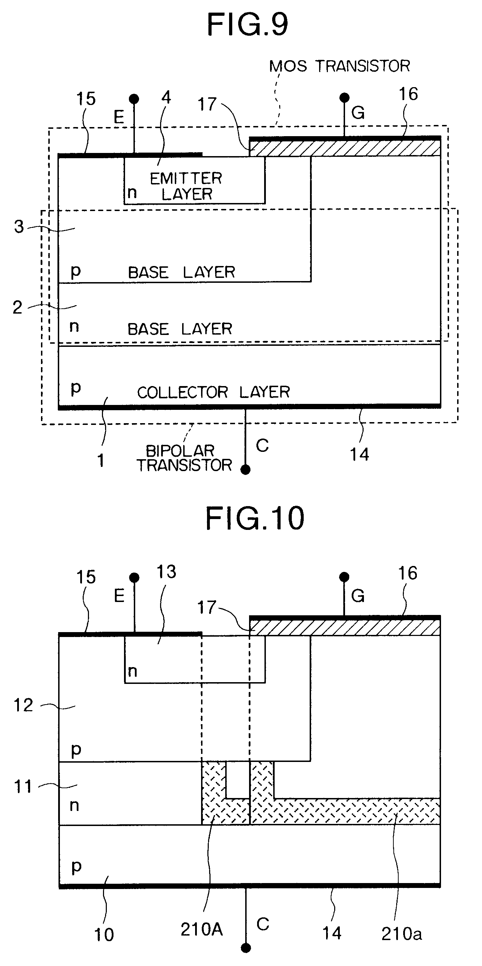

Recently, an insulated gate bipolar transistor (i.e., IGBT) receives a remarkable attention in the field of power switching devices. As shown in FIG. 9, insulated gate bipolar transistor has an MOS (metal oxide semiconductor) transistor (i.e., MOSFET) structure and a bipolar transistor structure together. More specifically, as shown in FIG. 9, a p-type collector layer 1, an n-type base layer 2 and a p-type base layer 3 constitute a bipolar transistor, and the n-type base layer 2, the p-type base layer 3 and an n-type emitter layer 4 constitute an MOS transistor. The bipolar transistor and the MOS transistor are connected together via the above-mentioned semiconductor layers 2 and 3. Therefore, in the insulated gate bipolar transistor, when a gate electrode 16 is placed in its ON-state to flow a current based on the MOSFET structure, a conductivity in the bipolar transistor at its portion corresponding to the base layer 2 is modulated by this current and a conductivity in the base layer 2 is increased. As a consequence, a current based on the bipolar transistor structure also is flowed and thus an on-resistance can be lowered as compared with that of the MOSFET structure.

In the insulated gate bipolar transistor, however, once an npnp structure included within the device operates as a thyristor, the switching operation by the gate electrode cannot be made, which is a problem that might be called a latch-up of a parasitic thyristor.

The latch-up of the parasitic thyristor occurs when a junction between the emitter layer 4 and the adjacent base layer 3 are forward-biased by a voltage drop generated by a seet-resistance of the base layer 3 adjoining the emitter layer 4. As one of means that can prevent the latch-up of the parasitic thyristor, there have heretofore been used a method for increasing a doping concentration of the base layer 3 adjacent to the emitter layer 4 as is described in IEEE Electron Device Letters, Vol. EDL-6, No. 7, Jul. 1985, pp. 378 - 380, Extended Abstracts of the 16th (1984 International) Conference on Solid State Devices and Materials, Kobe, 1984, pp. 309 - 312, IEDM Tech. Dig., 1984, pp. 860 - 861. According to this conventional method, since the seet-resistance of the base layer 3 adjacent to the emitter layer 4 is lowered, the voltage drop can be suppressed and the latch-up of the parasitic thyristor can be prevented.

Further, even when the flow of current based on the MOSFET structure is stopped by placing the gate electrode 16 in its OFF-state, the insulated gate bipolar transistor keeps flowing a current until majority carriers in the collector layer 1 injected into the base layer 2 adjacent to the collector layer 1 are all lost. A turn-off time of the insulated gate bipolar transistor is increased as compared with that of the MOSFET accordingly. As one of means for reducing a turn-off time of the insulated gate bipolar transistor, there has heretofore been used a method of doping a lifetime killer into the base layer 2 adjacent to the collector layer 1 as is described in IEEE TRANSACTIONS ON ELECTRON DEVICE, VOL. ED-24, No. 6, June 1977, pp. 685 - 688. According to this previously-proposed method, majority carriers in the collector layer 1 injected into the base layer 2 adjacent to the collector layer 1 become easy to be lost so that the turn-off time can be reduced.

Although the above-mentioned conventional methods can either prevent the latch-up of the parasitic thyristor or reduce the turn-off time in the insulated gate type bipolar transistor, these methods cannot improve the above-mentioned two problems at the same time.

Furthermore, although the insulated gate bipolar transistor in which the doped concentration of the base layer adjacent to the emitter layer is increased according to the prior art can prevent the latch-up of the parasitic thyristor, a doped concentration in the channel forming portion is increased, thereby a threshold voltage being changed. On the other hand, although the insulated gate bipolar transistor in which the lifetime killer is doped into the base layer according to the prior art can reduce the turn-off time, much more majority carriers are lost within the base layer 2 adjacent to the collector layer even when the gate switch is in its ON-state. Therefore, it is unavoidable that the on-resistance is increased. As described above, there is then the problem that the above-mentioned conventional methods prevent the latch-up of the parasitic thyristor or reduce the turn-off time at the cost of other characteristics.

### SUMMARY OF THE INVENTION

It is an object of the present invention to provide an insulated gate bipolar transistor in which a latch-up of a parasitic thyristor can be prevented and in which a turn-off time can be reduced.

It is another object of the present invention to provide an insulated gate bipolar transistor which can realize either of or both of the effects that a latch-up of a parasitic thyristor is prevented and a turn-off time is reduced while other characteristics are not spoiled.

To achieve the aforesaid objects, according to the present invention, there is provided an insulated gate bipolar transistor in which majority carriers in a collector layer 1 can be prevented from being injected into arbitrary regions extended from a region of an under layer of a gate electrode 16 provided within an adjacent base layer 2 to region except an under layer of an emitter electrode 15 provided within the base layer 2 adjacent to the collector layer 1 from the collector layer 1 by forming a potential barrier for majority carriers in the collector layer 1 within the base layer 2 adjacent to the collector layer 1.

Alternatively, according to the present invention, there is provided an insulated gate bipolar transistor in which majority carriers in the collector layer 1 can be prevented from flowing into an emitter electrode 15 from the collector layer 1 through the under layer of the gate electrode 16 provided within the base layer 2 adjacent to the collector layer 1 across the base layer 3 adjacent to the emitter layer 4 by forming a potential barrier to the majority carriers in the collector layer 1 within the base layer 2 adjacent to the collector layer 1.

In the insulated gate bipolar transistor shown in FIG. 9, the voltage drop that causes the latch-up of the parasitic thyristor occurs when the majority carrier in the collector layer 1 is injected from the collector layer 1 into the under layer of the gate electrode 16 provided within the base layer 2 adjacent to the collector layer 1 and the majority carrier further flows into the emitter electrode 15 across the base layer 3 adjacent to the emitter layer 4.

Further, since an electric field between the emitter electrode 15 and the collector electrode 14 is weak in the region covering the region of the under layer of the gate electrode to the region except the under layer of the emitter electrode 15, the majority carrier in the collector layer 1 injected into this area is difficult to be extracted into the emitter electrode 15. As a consequence, the majority carrier that was injected from the collector layer 1 into the regions except the under layer of the emitter electrode 15 provided within the base layer 2 adjacent to the collector layer 1 remains within the base layer 2 for a long period of time, which unavoidably extends the turn-off time of the insulated gate bipolar transistor.

Therefore, according to the present invention, since the majority carrier in the collector layer 1 from the collector layer 1 can be prevented from being injected into the region covering from the region of the under layer of the gate electrode 16 provided within the base layer 2 adjacent to the collector layer 1 to the region except the under layer of the emitter electrode 15 by the potential barrier formed in the insulated gate bipolar transistor, the latch-up of the parasitic thyristor can be prevented and the turn-off time can be reduced at the same time. Further, according to the present invention, since the doped concentration and the lifetime of the carrier can be prevented from being changed in the channel forming portion, other characteristics of the insulated gate bipolar transistor can be prevented from being lost.

Furthermore, according to the present invention, since the majority carrier in the collector layer 1 can be prevented from flowing into the emitter electrode 15 from the under layer of the gate electrode 16 provided within the base layer 2 adjacent to the collector layer 1 across the base layer 3 adjacent to the emitter layer 4, the latch-up of the parasitic thyristor can be prevented.

### BRIEF DESCRIPTION OF THE DRAWINGS

FIG. 1 is a diagram showing an insulated gate bipolar transistor according to a first embodiment of the present invention;
FIG. 2 is a diagram showing the insulated gate bipolar transistor according to a second embodiment of the present invention;
FIG. 3 is a diagram showing the insulated gate bipolar transistor according to a third embodiment of the present invention;
FIG. 4 is a diagram showing a first modified example of the insulated gate bipolar transistor according to the third embodiment of the present invention;
FIG. 5 is a diagram showing a second modified example of the insulated gate bipolar transistor according to the third embodiment of the present invention;
FIG. 6 is a diagram showing a third modified example of the insulated gate bipolar transistor according to the third embodiment of the present invention;
FIG. 7 is a diagram showing the insulated gate bipolar transistor according to a fourth embodiment of the present invention;
FIG. 8 is a diagram showing a modified example of the insulated gate bipolar transistor according to the fourth embodiment of the present invention;
FIG. 9 is a cross-sectional view showing a structure of a conventional insulated gate bipolar transistor;
FIG. 10 is a cross-sectional view used to explain a first principle of the present invention;
FIG. 11 is a cross-sectional view used to explain a second principle of the present invention;
FIG. 12 is a diagram used to explain a process 1 of a manufacturing method according to the second embodiment of the present invention;
FIG. 13 is a diagram used to explain a process 2 of the manufacturing method according to the second embodiment of the present invention;
FIG. 14 is a diagrams used to explain a process 3 of the manufacturing method according to the second embodiment of the present invention;
FIG. 15 is a diagram used to explain a process 4 of the manufacturing method according to the second embodiment of the present invention;
FIG. 16 is a diagram used to explain a process 5 of the manufacturing method according to the second embodiment of the present invention;
FIG. 17 is a diagram used to explain a process 6 of the manufacturing method according to the second embodiment of the present invention;
FIGS. 18A and 18B are diagrams used to explain a process 1 of a manufacturing method according to a third embodiment of the present invention, respectively; and
FIGS. 19A and 19B are diagrams used to explain a process 2 of the manufacturing method according to the third embodiment of the present invention, respectively.

### DESCRIPTION OF THE PREFERRED EMBODIMENTS

The present invention is based on any one of the following two principles.

According to the first principle, in an insulated gate bipolar transistor, as shown in FIG. 10, holes can be prevented from being injected from a region covering the under layer of the gate electrode 16 provided within an n-type base layer 11 to a region except the under layer of the emitter electrode 15 by forming a potential barrier to holes serving as majority carriers in a p-type collector layer 10 at the boundary of the p-type collector layer 10 within the n-type base layer 11 so that a latch-up of a parasitic thyristor can be prevented and that a turn-off time can be reduced. As shown in FIG. 10, according to the first principle, the potential barrier is formed at the boundary of the p-type collector layer 10 formed within the n-type base layer 11, and the end portion of the potential barrier is formed at any position within an range of the region (210A) except the region covering from a region (210a) of the under layer of a gate electrode 16 to the under layer of an emitter electrode 14.

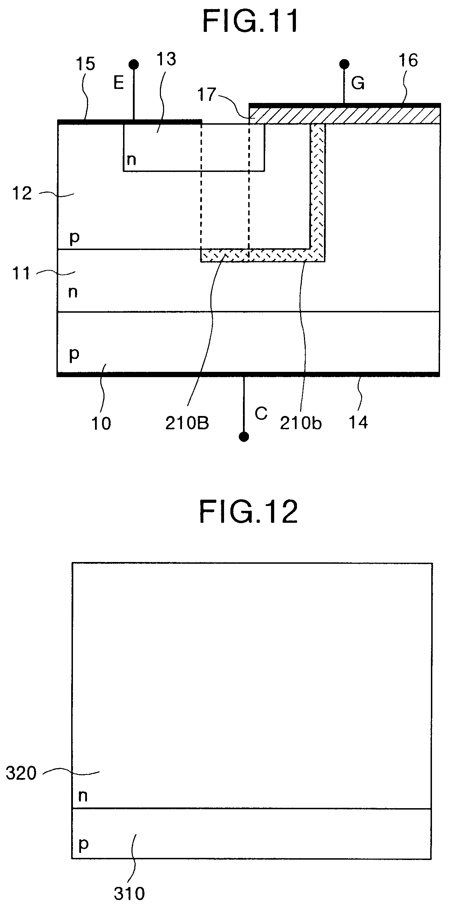

According to the second principle, in the insulated gate bipolar transistor, as shown in FIG. 11, holes can be prevented from flowing to the emitter electrode 15 from the under layer of the gate electrode 16 formed within the n-type base layer 11 through the p-type base layer 12 by providing the potential barrier to holes serving as majority carriers in the p-type collector layer 10 at the boundary of the p-type base layer 12 formed within the n-type base layer 11 so that a turn-off time can be reduced. As shown in FIG. 11, according to the second principle, the potential barrier is formed at the boundary of the p-type base layer 12 formed within the n-type base layer 11, and the end portion of the potential barrier is formed at any position within a range from a region (210b) of the under layer of the gate electrode 16 to a region (210B) except the under layer of the emitter electrode 15.

Embodiments that can embody these principles will be described with reference to the drawings. In the following embodiments, a first conductivity type is a p type, and a second conductivity type is an n type. The present invention can be similarly applied to embodiments in which a first conductivity type is an n type and a second conductivity type is an n type. In the following description, the insulated gate type bipolar transistor will be simply referred to as an IGBT.

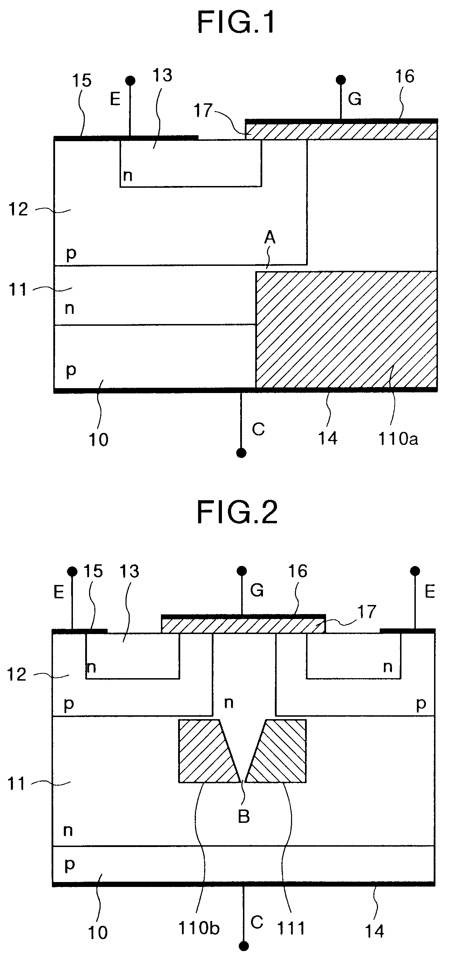

FIG. 1 is a cross-sectional view of the IGBT according to a first embodiment of the present invention. One of the most specific features of the present invention lies in that the whole of the p-type collector layer 10 formed under the gate electrode 16 and a region except the portion adjoining the p-type base layer 12 formed within the n-type base layer 11 formed under the gate electrode 16 are replaced with an insulator 110a, such as SiO₂ or the like.

If the IGBT is arranged as shown in FIG. 1, then the insulator 110a serves as a potential barrier to holes, and therefore the holes can be prevented from being injected into the n-type base layer 11 formed under the gate electrode 16. Therefore, according to the first principle, the latch-up o the parasitic thyristor can be prevented, and the turn-off time can be reduced at the same time. Also, in the structure shown in FIG. 1, the doped concentration at the channel forming portion and the lifetime of the carrier are not changed. Therefore, without deterioration of other characteristics, such as when a threshold voltage is changed by the increase of the doped concentration of the channel forming portion and when an on-resistance is increased by the decrease of the lifetime, the latch-up of the parasitic thyristor can be prevented and the turn-off time can be reduced at the same time.

The reason that the n-type base layer 11 formed under the gate electrode 16 at its portion (shown by A in FIG. 1) adjoining the p-type base layer 12 is not replaced with the insulator 110a is to cause an electron current provided by the MOSFET structure to flow through this portion (A) to the collector electrode. Accordingly, the region (A) that was left in the n-type base layer 11 under the gate electrode 16 without being replaced with the insulator 110a may be reduced as much as possible in a range in which an electron current required by the device to operate can be obtained.

Further, in the structure shown in FIG. 1, there is then the possibility that holes will be injected into the n-type base layer 11 of the region except the under layer of the emitter electrode 15 through the region (A) left in the n-type base layer 11 under the gate electrode 16 without being replaced with the insulator 110a. However, a quantity of holes is very small and whose influence exerted upon device characteristics can be neglected. Further, in the n-type base layer 11, if a region over the insulator 110a is replaced with an n-type polycrystal of a semiconductor constructing other regions, then a lifetime of the hole on this region is reduced and therefore the influence of the hole injected into this region can be further reduced.

An example of a manufacturing method of the IGBT according to the present invention shown in FIG. 1 will be described below. Initially, on a p-type Si substrate which serves as the p-type collector layer 10 are formed an n-type base layer 11, a p-type base layer 12 and an n-type emitter layer 13 by an epitaxial growth method or diffusion method. Then, Si which is replaced with an insulator is removed by patterning the rear surface of the p-type Si substrate by using a resist and effecting the dry etching. Subsequently, the insulator 110a is formed on the region in which Si was removed by a CVD (chemical vapor deposition) method, whereafter the resist is removed and a gate insulating film 17, a gate electrode 16, an emitter electrode 15 and a collector electrode 14 are formed by a CVD method and a deposition method. With the above-mentioned processes, the IGBT according to the present invention shown in FIG. 1 is completed.

A second embodiment of the present invention will be described with reference to FIG. 2. FIG. 2 is a cross-sectional view showing the IGBT according to the second embodiment of the present invention. FIG. 2 shows the state that two unit cells having the gate electrode 16 commonly are integrated. One of the most specific characteristics of the second embodiment of the present invention lies in that the lower portion of the p-type base layer 12 are replaced with an insulator 110b and an insulator 111, such as SiO₂ or the like, in the n-type base layer 11 formed under the gate electrode 16. Also, in the n-type base layer 11 in the region except the under layer of the emitter electrode 15, a region sandwiched by the two p-type base layers 12 and a region sandwiched by the insulators 110b and 111 may be replaced with an n-type polycrystal of semiconductor constructing other regions. A spacing (shown by B in FIG. 2) between the two insulators 110b and 111 is used to cause the electron current based on the MOSFET structure to flow through this portion (B) into the collector electrode 14.

If the IGBT is arranged as shown in FIG. 2, then similarly to the first embodiment, the latch-up of the parasitic thyristor can be prevented and the turn-off time can be reduced at the same time according to the above-mentioned first principle. Also, other characteristics can be prevented from being deteriorated and the polycrystal semiconductor effects can be achieved similarly to the first embodiment of the present invention.

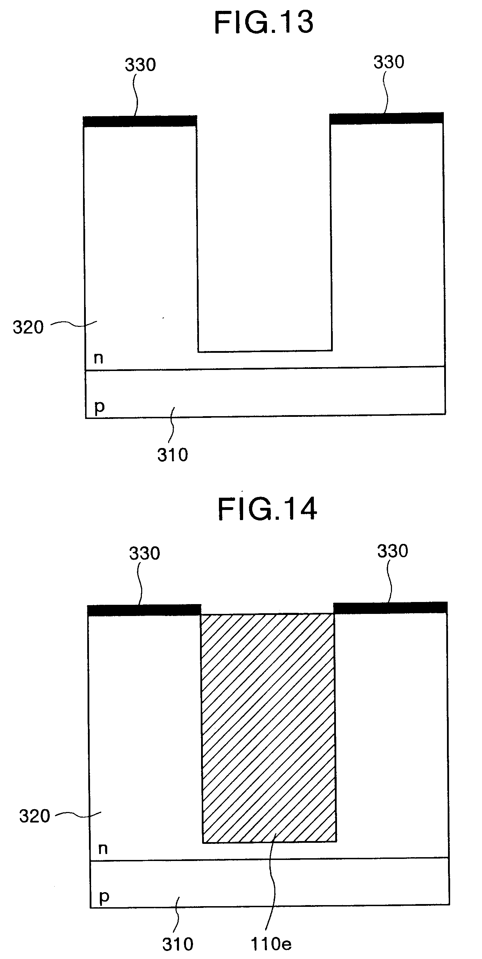

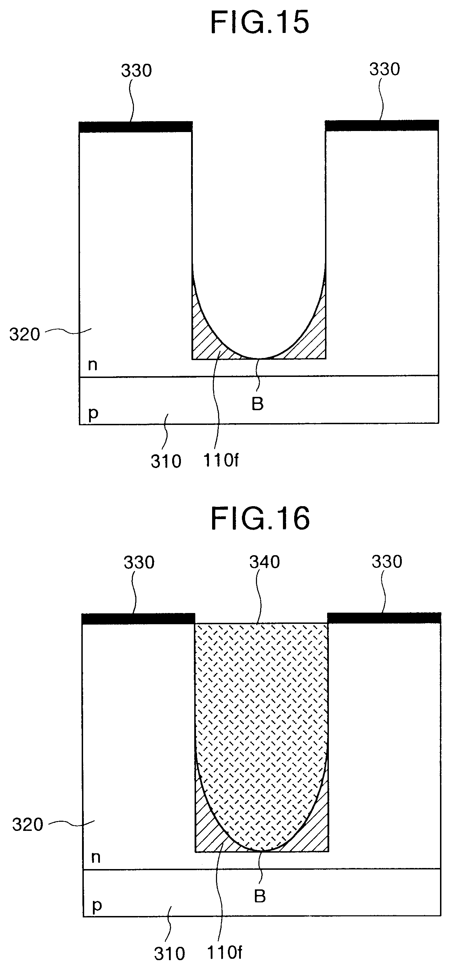

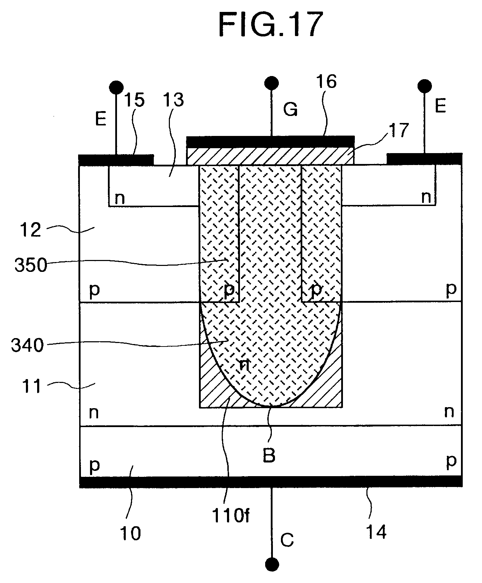

An example of the manufacturing method of the IGBT according to the present invention shown in FIG. 2 will be described below with reference to FIGS. 12 through 17. Initially, as shown in FIG. 12, on a p-type Si substrate 310 which serves as the p-type collector layer 10 is formed an n-type epitaxial Si layer 320 by an epitaxial growth method (process 1). Then, as shown in FIG. 13, Si in the region which is replaced with the insulator is removed by patterning the surface of the n-type epitaxial Si layer 320 by using a resist 330 and by a dry etching (process 2). Then, as shown in FIG.14, an insulator 110e is formed on the region from which Si was removed by a CVD method (process 3). As shown in FIG. 15, a wet etching is carried out so as to leave an insulator 110f of a desired shape (process 4). At that time, as earlier noted, in order to cause the electron current based on the MOSFET structure to flow to the collector electrode 14, a spacing (B) is provided between the two insulators 110f. Then, as shown in FIG. 16, the portion from which Si was removed by the CVD method is buried by an n-type polycrystal Si 340 (process 5), whereafter a p-type base layer 12, a p-type polycrystal Si 350 and an n-type emitter layer 13 are formed by a diffusion method. Further, a gate insulating film 17, a gate electrode 16, an emitter electrode 15 and a collector electrode 10 are formed by a CVD method and a deposition method (process 6). Then, as shown in FIG. 17, the IGBT according to the second embodiment of the present invention is completed.

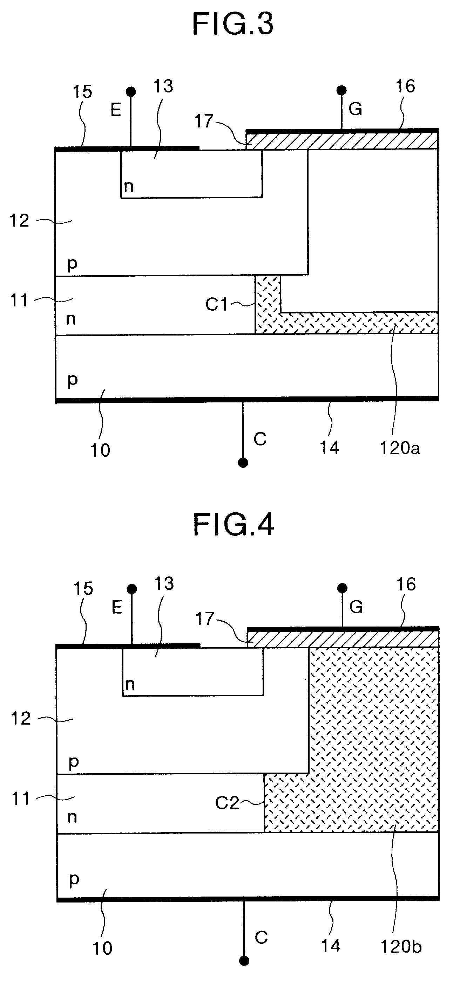

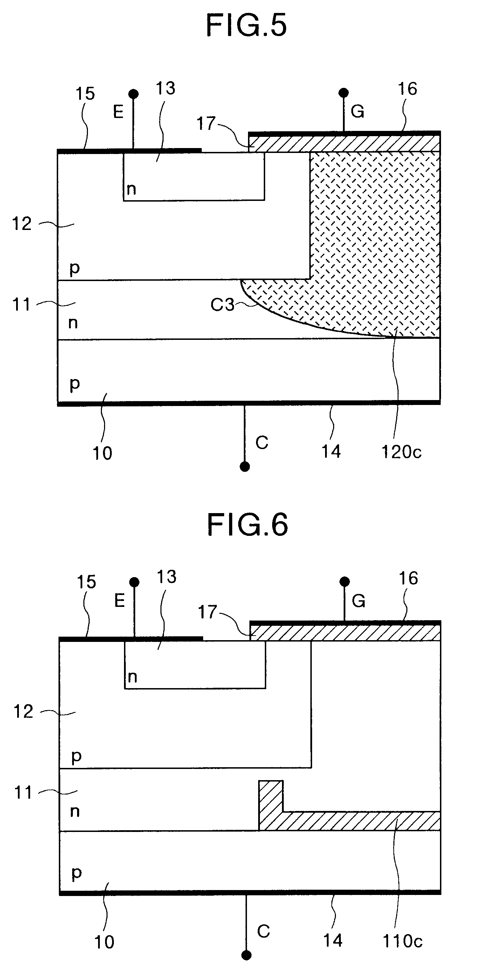

A third embodiment of the present invention will be described next with reference to FIG. 3. FIG. 3 is a cross-sectional view showing the IGBT according to the third embodiment of the present invention. The most specific feature of the third embodiment lies in that an n-type impurity highly doped layer 120a is formed by providing a continuous or discontinuous n-type impurity concentration distribution or that a potential barrier for holes is formed on the n-type base layer 11 by forming a heterojunction by replacing the n-type base layer 11 under the gate electrode 16 with the semiconductor layer 120a having a bandgap energy different from that of Si. Further, if the IGBT is arranged as shown in FIG. 4 or 5, then a similar potential barrier can be formed. FIG. 4 shows a first modified example of the third embodiment in which the whole of the n-type base layer 11 of the under layer of the gate electrode 16 is formed as the potential barrier 120b. FIG. 5 shows a second modified example of the third embodiment in which the potential 120b shown in FIG. 4 is represented by a potential barrier 120c that is formed by etching methods shown in FIGS. 15 and 16.

End portions c1, c2 and c3 of the potential barriers shown in FIGS. 3, 4 and 5 can function as potential barriers even when they are extended near the emitter electrode 15, as shown in FIG. 10.

In the structure in which the n-type impurity highly doped region is formed as in the third embodiment, the n-type impurity highly doped region becomes the potential barrier for the holes so that the holes can be prevented from being injected into the n-type base layer 11 of the under layer of the gate electrode 16. Therefore, according to the first principle, the latch-up of the parasitic thyristor can be prevented and the turn-off time can be reduced at the same time. Also, other characteristics can be prevented from being deteriorated similarly to the first embodiment of the present invention. Since the electron current flows also into the n-type impurity highly doped region, an n-type doping concentration can be increased up to the portion which adjoins the p-type base layer 12.

In the structure shown in FIGS. 3 to 5, a breakdown voltage of the device can be secured by providing a continuous or discontinuous n-type doping concentration distribution within a region in which an n-type doping concentration is high.

Further, in the structure having the heterojunction according to this embodiment, the heterojunction can be served a the potential barrier only for holes by adjusting a semiconductor material and a doping concentration of the replaced portion. Therefore, according to the above-mentioned structure, it is possible to prevent holes from being injected into the n-type base layer 11 formed under the gate electrode 16. Thus, according to the first principle, the latch-up of the parasitic thyristor can be prevented and the turn-off time can be reduced at the same time. Further, other characteristics can also be prevented from being deteriorated similarly to the first embodiment of the present invention. Since the heterojunction is served as the potential barrier only for holes, the electron current can flow in the heterojunction. Accordingly, the heterojunction can be formed up to the portion adjoining the p-type base layer 12.

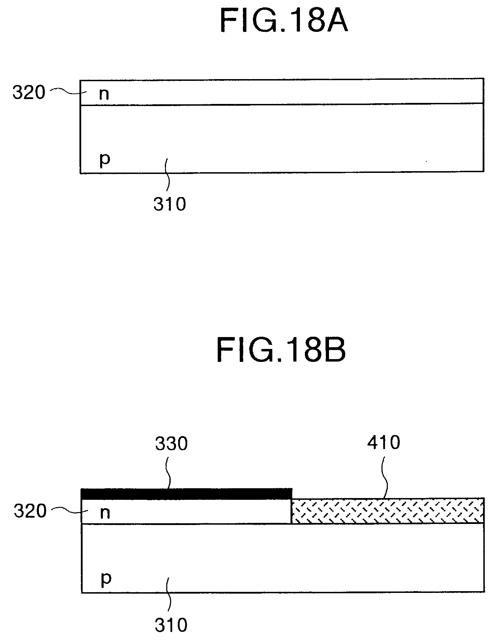

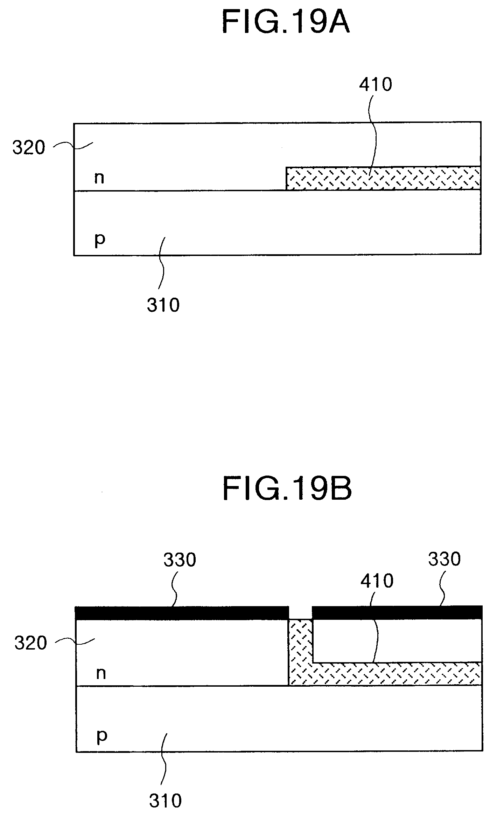

An example of a manufacturing method of the IGBT according to the third embodiment of the present invention shown in FIG. 3 will be described below with reference to FIGS. 18 and 19. Initially, in the process 1, as shown in FIG. 18A, an n-type epitaxial Si layer 320 is formed on a p-type Si substrate 310 serving as a p-type collector layer by an epitaxial growth method. Subsequently, as shown in FIG. 18B, the surface of the n-type epitaxial Si layer 320 is patterned by a resist 330, and a highly-doped layer 410 of an n-type impurity is formed at a boundary between it and the p-type Si substrate 310 by a diffusion method or-high energy ion implantation method. In the next process 2, the resist 330 is removed, and an n-type Si layer is epitaxially grown on the whole surface as shown in FIG. 19A. Then, as shown in FIG. 19B, the surface of the n-type epitaxial Si layer 320 is patterned by the resist 330, and a highly-doped layer 410 of n-type impurity is formed at a desired position by a diffusion method or high energy ion implantation method. Then, the resist 330 is removed, and an n-type Si layer is epitaxially grown, whereafter a p-type base layer and an n-type emitter layer are formed by a diffusion method. Further, a gate insulated film, a gate electrode, an emitter electrode and a collector electrode are formed by a CVD method and a deposition, thereby completing the IGBT according to the third embodiment of the present invention shown in FIG. 3.

While the n-type impurity highly-doped layer is formed according to the above-mentioned method, the present invention is not limited thereto. For example, if an implantation of other chemical elements than Si is carried out similarly to the above implantation of n-type impurity, then the IGBT having the heterojunction according to the present invention can be manufactured.

Further, the present invention is also effective in the case that the insulator is used as the potential barrier as shown in FIG. 6 which shows the third modified example of the third embodiment. Such structure as shown in FIG. 6 also can be manufactured if an implantation of chemical element such as oxygen is carried out similarly to the above n-type impurity implantation. In this case, in order to cause electron current based on the MOSFET structure to flow, the region adjoining the p-type base layer is not replaced with the insulator.

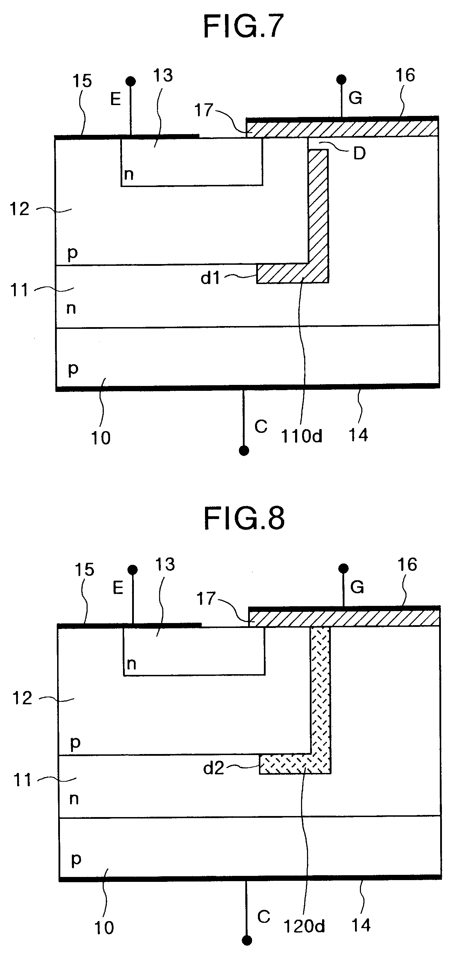

A fourth embodiment will be described with reference to FIG. 7. FIG. 7 is a cross-sectional view of the IGBT according to the fourth embodiment of the present invention. The most specific feature of this embodiment lies in that a potential barrier for hole is formed by replacing only a boundary between a range from the region of the under layer of the gate electrode 16 of the n-type base layer 11 to a region other than the under layer of the emitter electrode 15 and the p-type base layer 12 with an insulator 110d. According to the structure shown in FIG. 7, even when the hole is injected into the region ranging from the under layer of the gate electrode 16 of the n-type base layer 11 to the region other than the under layer of the emitter electrode 15, the hole can be prevented from being injected into the emitter electrode 15 through the p-type base layer 12. Therefore, the latch-up of the parasitic thyristor can be prevented by the second principle shown in FIG. 11.

In order to cause the electron current based on the MOSFET structure to flow, the region (shown by D in FIG. 7) adjacent to the gate is not replaced with the insulator. Further, in the structure shown in FIG. 7, when a boundary between the region ranging from the under layer of the gate electrode 16 of the n-type base layer 11 to the region other than the under layer of the emitter electrode 15 and the p-type base layer 12 is replaced with a material forming the potential barrier only for holes by the n-type impurity highly-doped layer 120 or the semiconductor layer 120d having a bandgap energy different from that of Si, a region that adjoins the gate may be replaced with the above-mentioned material as shown in FIG. 8 which shows a modified example of the fourth embodiment.

End portions d1 and d2 of the potential barriers shown in FIGS. 7 and 8 can function as the potential barriers even when they are extended near the emitter electrode 15 as shown in FIG. 11. The IGBT according to this embodiment also can be manufactured by a method similar to that of the third embodiment.

While all collector layers described so far are of the p-type conductivity type, the present invention is effective if the conductivity type is reversed. More specifically, the present invention can be applied even when the collector layer 1 is of the n type, the base layer 2 is of the p type, the base layer 3 is of the n type and the emitter layer 4 is of the p type in the drawings and description of the above-mentioned embodiments. In that case, the potential barrier can prevent electrons serving as majority carrier in the collector layer 1 from being injected into the region of the under layer of the emitter electrode 15 from the collector layer 1 through the region of the under layer of the gate electrode 16.

Further, the present invention is made effective if semiconductor substrates other than the Si substrate are used. Furthermore, while the unit cell has been described so far, when the insulated gate bipolar transistor is used in actual practice, a plurality of unit cells are integrated in use.

According to the present invention, in the insulated gate bipolar transistor, the majority carrier in the collector layer can be prevented from being injected into the region ranging from the region of the under layer of the gate electrode of the base layer adjacent to the collector layer to the region except of the under layer of the emitter electrode by providing the potential barrier for the majority carrier from the collector layer within the base layer adjacent to the collector layer without changing the doping concentration in the channel forming portion and the lifetime of the carrier. Therefore, the latch-up of the parasitic thyristor can be prevented and the turn-off time can be reduced at the same time without deteriorating other characteristics.

Furthermore, when the majority carrier from the collector layer can be prevented from flowing into the emitter electrode through the region from the region of the under layer of the gate electrode of the base layer adjacent to the collector layer to the region other than the under layer of the emitter electrode and also via the base layer adjacent to the emitter layer by providing the potential barrier for the majority carrier from the collector layer at the boundary between the base layer adjacent to the collector layer and another base layer adjacent to the collector layer, the latch-up of the thyristor can be prevented without deteriorating other characteristics.

## Claims

1. An insulated gate bipolar transistor comprising:
a first conductivity type base layer (12) formed on an inner region from a surface of a portion of a second conductivity type base layer (11) laminated on a first conductivity type collector layer (10);
a second conductivity type emitter layer (13) formed on an inner region from a surface of a portion of said first conductivity type base layer (12);
an emitter electrode (15) formed adjacent to the surface of said first conductivity type base layer (12) and a portion of the surface of said second conductivity type emitter layer (13); and
a gate electrode (16) opposed to said emitter electrode (15) through said second conductivity type emitter layer (13) and across the surface of the first conductivity type base layer (12) and the surface of said second conductivity type base layer (11), wherein a potential barrier for preventing a first conductivity type majority carrier from being injected into an arbitrary region including a first region from said first conductivity type collector layer (10) to a region except an under layer of a region adjacent to said emitter electrode (15) of said second conductivity type base layer (11) is formed at a boundary formed at any position from an under layer of said first region in which both of said first conductivity type base layer (12) within said second conductivity base layer (11) and said second conductivity type base layer (11) adjoin said insulated layer (17) to the under layer of the region adjacent to said emitter electrode (15) and in the region adjacent to said first conductivity type collector layer (10).

2. The transistor of claim 1, wherein said region except said potential barrier is formed of a second conductivity type polycrystal of a semiconductor forming other regions in a region other than the under layer of said emitter electrode (15) of said second conductivity type base layer (13).

3. The transistor of claim 1, wherein said region except said potential barrier is formed of a second conductivity type polycrystal of a semiconductor forming other regions in a region other than the under layer of said gate electrode (16) of said second conductivity type base layer (11).

4. An insulated gate bipolar transistor comprising:
a first conductivity type base layer (12) formed from a surface of a portion of a second conductivity type base layer (11) laminated on a first conductivity type collector layer (10) to an inner region;
a second conductivity type emitter layer (13) formed from a surface of a portion of said first conductivity type base layer (12) to an inner region;
an emitter electrode (15) formed adjacent to the surface of said first conductivity type base layer (12) and across a portion of a surface of said second conductivity type emitter layer (13);
a gate electrode (16) opposed to said emitter electrode (15) through said second conductivity type emitter layer (13) and across a surface of said first conductivity type base layer (12) and a surface of said second conductivity type base layer (11); and
a potential barrier for preventing a first conductivity type majority carrier from being injected into an arbitrary region from said first conductivity type collector layer (10) including a region in which both of said first conductivity type base layer (12) within said second conductivity type base layer (11) and said second conductivity type base layer (11) adjoin said insulated layer (17) to a region except an under layer of a region adjacent to said emitter electrode (15) of said second conductivity type base layer (11).

5. An insulated gate bipolar transistor comprising:
a first conductivity type base layer (12) formed on a surface of a portion of a second conductivity type base layer (11) laminated on a first conductivity type collector layer (10) to an inner region;
a second conductivity emitter layer (13) formed from a surface of a portion of said first conductivity type base layer (12) to an inner region;
an emitter electrode (15) formed adjacent to the surface of said first conductivity type base layer (12) and across a portion of the surface of said second conductivity type emitter layer (13); and
a gate electrode (16) opposed to said emitter electrode (15) through said second conductivity type emitter layer (13) and across the surface of said first conductivity type base layer (12) and the surface of said second conductivity type base layer (11) through an insulated layer (17), wherein a potential barrier for preventing a first conductivity type majority carrier from being injected from an arbitrary region ranging from a first region of said second conductivity type base layer (11) to a region except an under layer of said emitter electrode (15) to said emitter electrode (15) through said first conductivity type collector layer (10) is formed from a boundary formed at any position between an under layer of said first region in which both of said first conductivity type base layer (12) within said second conductivity type base layer (11) and said second conductivity type base layer (11) adjoin said insulated layer (17) and an under layer of a region adjacent to said emitter electrode (15) to a region adjacent to said first conductivity type base layer (12) to a position in which said first conductivity type base layer (12), said second conductivity type base layer (11) and said insulated layer are brought in contact with each other.

6. An insulated gate bipolar transistor comprising:
a first conductivity type base layer (12) formed from a surface of a portion of a second conductivity type base layer (11) laminated on a first conductivity type collector layer (10);
a second conductivity type emitter layer (13) formed from a surface of a portion of said first conductivity type base layer (12) to an inner region;
an emitter electrode (15) formed adjacent to the surface of said first conductivity type base layer (12) and across a portion of the surface of said second conductivity type emitter layer (13);
a gate electrode (16) opposed to said emitter electrode (15) through said second conductivity type emitter layer (13) and across the surface of said first conductivity type base layer (12) and the surface of said second conductivity type base layer (11) through an insulated layer (17); and
a potential barrier for preventing a first conductivity type majority carrier from being injected into said emitter electrode (15) through said first conductivity type collector layer (10) from an arbitrary region ranging from a region in which both of said first conductivity type base layer (12) within said second conductivity type base layer (11) and said second conductivity type base layer (11) adjoin said insulated layer (17) to a region except an under layer of said emitter electrode (15).

7. An insulated gate bipolar transistor comprising:
a first conductivity type base layer (12) formed from a surface of a portion of a second conductivity type base layer (11) laminated on a first conductivity type collector layer (10) to an inner region;
a second conductivity type emitter layer (13) formed from a surface of a portion of said first conductivity type base layer (12) to an inner region;
an emitter electrode (15) formed adjacent to the surface of said first conductivity type base layer (12) and across a portion of the surface of said second conductivity type emitter layer (13); and
a gate electrode (16) opposed to said emitter electrode (15) through said second conductivity type emitter layer (13) and across the surface of said first conductivity type base layer (12) and the surface of said second conductivity type base layer (11), wherein a potential barrier for preventing a first conductivity type majority carrier from being injected into a region ranging from said first conductivity type collector layer to a region except an under layer of a region adjoining said emitter electrode of said second conductivity type base layer is formed in a region encircled by a boundary formed at any position between the under layer of a first region in which both of said first conductivity type base layer (12) within said second conductivity type base layer (11) and said second conductivity type base layer (11) adjoin said insulated layer (17) and the under layer of a region adjoining said emitter electrode (15), a boundary of said first conductivity type collector layer (10) and a boundary of said first conductivity type base layer (12).

8. The transistor of any one of claims 1 to 7, wherein said potential barrier is formed of an insulator or of a second conductivity type impurity highly-doped layer (110b, 111), or of a semiconductor having a bandgap energy different from that of a semiconductor forming a region except said potential barrier.

9. An insulated gate bipolar transistor comprising:
a first conductivity type base layer (12) formed from a surface of a portion of a second conductivity type base layer (11) laminated on a first conductivity type collector layer (10) to an inner region;
a second conductivity type emitter layer (13) formed from a surface of a portion of said first conductivity type base layer (12) to an inner region;
an emitter electrode (15) formed adjacent to the surface of said first conductivity type base layer (12) and across a portion of the surface of said second conductivity type emitter layer (13);
a gate electrode (16) opposed to said emitter electrode (15) through said second conductivity type emitter layer (13) and across the surface of said first conductivity type base layer (12) and the surface of said second conductivity type base layer (11) through an insulated layer (16); and
a potential barrier for preventing a first conductivity type majority carrier from being injected into a region ranging from said first conductivity type collector layer (10) to a region except an under layer of a region adjoining said emitter electrode (15) of said second conductivity type base layer (11).

10. An insulated gate bipolar transistor having a collector layer (10) to which a collector electrode (14) is connected, first and second base layers (11; 12) and an emitter layer (13) laminated one another, and an emitter electrode (15) adjacent to said emitter layer (13) and said second base layer and a gate electrode (16) adjacent to said first and second base layers (11; 12), comprising a potential barrier for a majority carrier from said collector layer formed within laid first base layer adjacent to said collector layer (10).

11. The transistor of claim 10, wherein said potential barrier is formed at a position such that majority carriers from said collector layer are prevented from being injected into a region ranging from a region of an under layer of said gate electrode (16) of said first base layer adjacent to said collector layer to a region except an under layer of said emitter electrode (15).

12. The transistor of claim 10, wherein said potential barrier is formed at a position such that majority carriers from said collector layer (10) are prevented from being injected into said emitter electrode (15) from a region of an under layer of said gate electrode (16) of said first base layer or region except an under layer of said emitter electrode (15) through said second base layer adjacent to said emitter layer (13).
